# EUROPEAN PATENT APPLICATION

(11) **EP 0 607 583 A2**
(43) Date of publication of application: **27.07.1994**
(21) Application number: 93120380.6
(22) Date of filing: 17.12.1993
(51) Int. Cl.: H01L 21/76

(54) **Improved isolation for high voltage/low voltage combined processes**

(30) Priority: 18.12.1992 US 993194
(71) Applicant: TEXAS INSTRUMENTS INCORPORATED, Dallas Texas 75265 (US)
(72) Inventor: Tigelaar, Howard L., Allen, TX 75002 (US); Mahant-Shetti, Shivaling, Richardson, TX 75082 (US)
(74) Representative: Schwepfinger, Karl-Heinz, Dipl.-Ing.

(57) **Abstract**

A method for isolating devices in a semiconductor body. A field plate 228 is embedded in a field oxide region 208 to isolate a device such as transistor 262 from other devices. Field plate 228 comprises a conductive material such as polysilicon and is electrically connected to well region 204. A portion of well region 204 below field plate 228 is doped to form channel stop 220. Insulator layer 230 is formed over field plate 228 to insulate field plate 228 from other device elements (not shown).

Other devices, systems and methods are also disclosed.

## Description

### FIELD OF THE INVENTION

This invention generally relates to semiconductor devices and processes and more specifically to isolation for high voltage/low voltage combined processes.

### BACKGROUND OF THE INVENTION

As the demand for more complex functions and higher performance in integrated circuits increases, it becomes necessary to pack active devices more densely. Density depends on the area required to isolate transistors from one another as well as upon the active area of transistors. Heretofore, in this field, it has become desirable to combine high voltage power devices with low voltage control logic on a single integrated circuit. However, when both high and low voltage were required on the same device, isolation has been problematic. Charge spreading from high voltage devices to low voltage devices can exceed the field threshold of low voltage devices and cause loss of isolation.

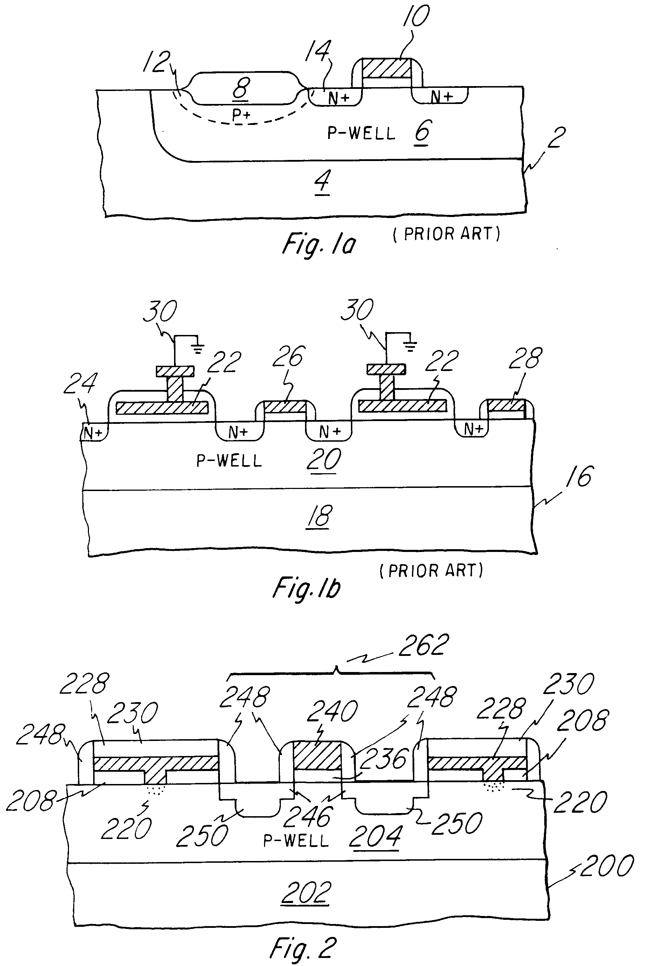

Several prior art techniques have been implemented in an attempt to overcome this problem. One prior art solution involved thickening the isolation oxide between devices. However, thickening the isolation oxide adversely impacts the moat-to-moat spacing. A second prior art solution is shown in Figure 1a. A channel stop region 12 is located below field oxide region 8 in p-well 6. The implant dose of the channel stop (C/S) region 12 is increased to improve isolation. However, when the C/S implant dose is increased the diode breakdown voltage between the C/S region 12 and the transistor source/drain 14 decreases causing leakage problems. A third prior art solution introduced a field plate 22 between susceptible devices (24 & 26, and 26 & 28) as shown in Figure 1b. The field plate 22 requires a connection 30 to ground. However, connection 30 takes up much needed device space and increases process complexity. Accordingly, an isolation scheme which overcomes the problems associated with prior art methods is desired.

### SUMMARY OF THE INVENTION

Generally, and in one form of the invention, a structure for isolating devices in a semiconductor body is disclosed. The structure comprises a first well region of a first conductivity type formed in the semiconductor body, first and second devices, and an oxide region located above the first region between the first and second devices. A field plate is embedded in the oxide region such that the field plate is electrically connected to the first well region.

### Objects of the Invention

It is an object of the invention to provide improved isolation between devices in a semiconductor body that requires minimal device area.

It is a further object of the invention to provide improved isolation between devices in a semiconductor body having both high voltage and low voltage devices.

It is a further object of the invention to provide improved isolation between devices in a semiconductor body that does not adversely impact diode breakdowns.

It is a further object of the invention to provide improved isolation between devices in a semiconductor body that employs a thin field oxide region.

It is a further object to provide high voltage isolation with reduced topography.

It is a further object to provide a ground plane to the chip that doesn't use metal interconnect resources.

### BRIEF DESCRIPTION OF THE DRAWINGS

In the drawings:
FIG. 1a-b are a cross-sectional views of prior art isolation techniques.
FIG. 2 is a cross-sectional view of a first preferred embodiment according to the invention.
FIG. 3a-f are cross-sectional views illustrating various states of fabrication of the first preferred embodiment of the invention.
FIG. 4 is a cross-sectional view of a second preferred embodiment according to the invention.
FIG. 5a-d are cross-sectional views illustrating various states of fabrication of the second preferred embodiment of the invention.
FIG. 6 is a cross-sectional view of a third preferred embodiment according to the invention.
FIG. 7a-d are cross-sectional views illustrating various states of fabrication of the third preferred embodiment of the invention.

Corresponding numerals and symbols in the different figures refer to corresponding parts unless otherwise indicated.

### DETAILED DESCRIPTION OF PREFERRED EMBODIMENTS

The field plate isolation according to the invention will be described herein as incorporated into a CMOS structure. It should of course be understood that field plate isolation according to the invention may be incorporated into integrated circuits which are constructed according to MOS, CMOS, bipolar, or BiCMOS technologies, each of which can utilize the benefits thereof.

A first preferred embodiment of the invention is shown in Figure 2 and will now be described. Field plate 228 is embedded in oxide layer 208, for example to isolate transistor 262 formed in p-well 204 from a second transistor (not shown) formed on the opposite side of field plate 228 from transistor 262. This structure may be formed in p-well 208 or in an n-well (not shown). Field plate 228 contacts p-well 204 through channel stop region 220 and may also serve as a ground plane to be contacted in subsequent processing. Oxide layer 230 covers field plate 228 and sidewall oxides 248 are located adjacent field plate 228. Sidewall oxides 248 isolate field plate 228 from other elements such as transistor 262.

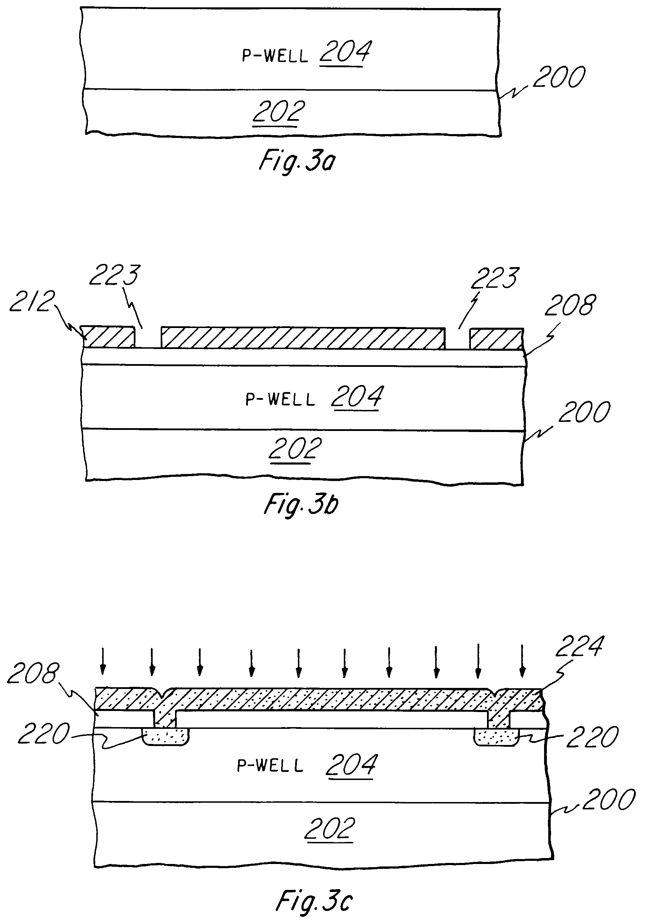

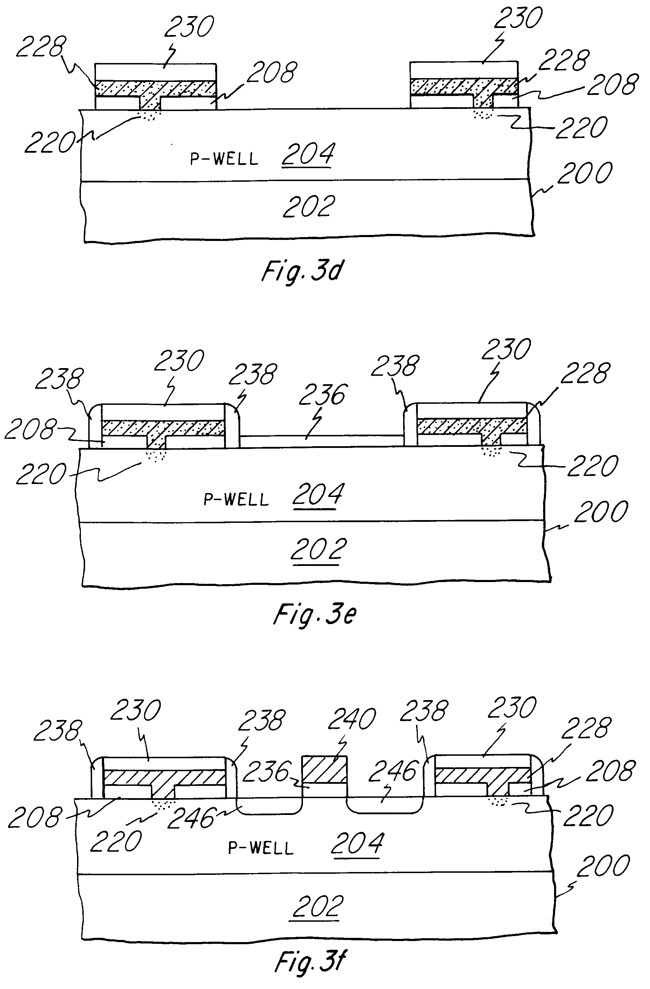

Figure 3a is cross-sectional diagram of a semiconductor body 200 having an n-type single crystal silicon substrate 202 after the formation of a p-well 204. The formation of a field plate isolation in the structure of Figure 3a will now be described.

Referring to figure 3b, oxide layer 208 is deposited or grown on the surface of semiconductor body 200. The thickness of oxide layer 208 is typically on the order of 500 Å. A masking layer 212, such as photoresist, is lithographically patterned as shown in Figure 3b to expose the area 223 of oxide layer 208 where the field plate 228 is to be formed. The width of field plate 228 depends on available area and is typically .8 microns or greater. Oxide layer 208 is etched by conventional techniques to expose a portion of p-well 204. An implant may then be used to increase the well concentrated in the exposed area 220. Masking layer 212 is then removed.

Next, a layer of conductive material 224 is deposited as shown in Figure 3c. In the preferred embodiment, layer 224 is polysilicon. However, it will be apparent to those skilled in the art that other materials such as refractory metal or silicide may also be used. The lower resistance materials would be preferred if the field plate layer is also to be used as the device ground plane. Typically, the thickness will range between 2000 and 4000 Å. If the layer is polysilicon, then conductive layer 224 is then doped according to conventional techniques to form the buried contact and channel stop region 220. For example, a patterned p+ implant may be used to dope the area of conductive layer 224 over p-well 204 (e.g., 1E15 to 1E16 phosphorous/cm²). If a polysilicon field plate were to be formed over an n-well (not shown) then a patterned n+ implant would be used over the n-well.

Oxide layer 230 is deposited over conductive layer 224 as shown in Figure 3d. Oxide layer 230 may, for example be a layer of TEOS oxide. The thickness of oxide layer 230 is on the order of 1000 to 2000 Å. Oxide layer 230, conductive layer 224 and oxide layer 208 are etched to expose portions of the surface of semiconductor body 200 where transistors, such as transistor 262, are to be formed. As a result of the etching step, field plate 228 is formed. Gate oxide layer 236 is then grown according to conventional techniques as shown in Figure 3e. During the growth of gate oxide layer 236, sidewall oxides 238 are formed on the vertical edges of oxide layer 230, field plate 228 and oxide layer 208 to isolate field plate 228 from subsequently processed elements such as transistor 262.

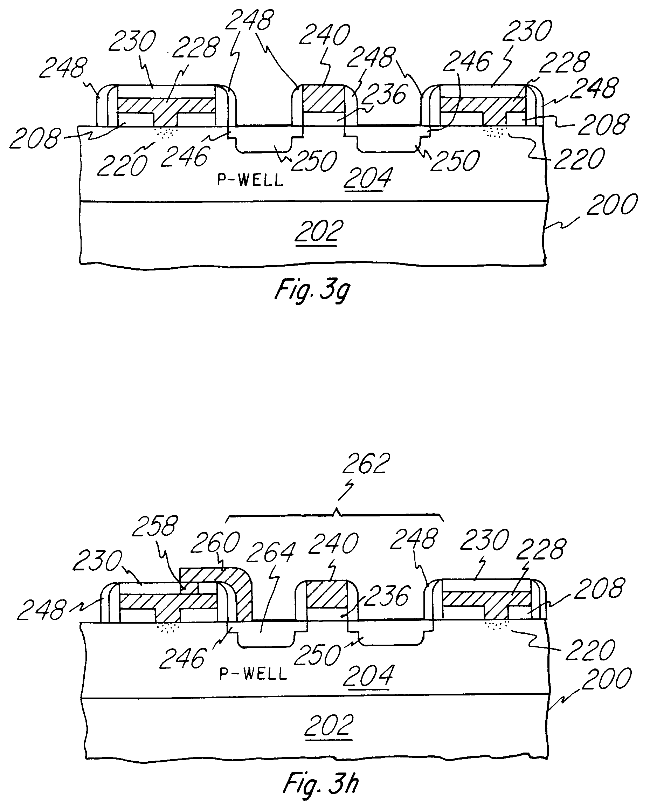

Subsequent to the completion of the method described above, transistors and other elements, as well as connections therebetween, are formed into semiconductor device 200. Methods for forming such elements are well known in the art. A preferred method for forming transistor 262 will now be described. A layer of polysilicon may be deposited and etched to form gates 240, as shown in Figure 3f. Preferably, a highly selective etch is used to prevent polysilicon filaments from forming around sidewall oxides 238. The exposed surface of semiconductor body 200 on both sides of the gate are then patterned and lightly doped to form the lightly doped drains (LDDs) 246. Referring to Figure 3g, a layer of oxide is deposited and anisotropically etched to form sidewall oxides 248. The source/drains 250 are implanted in the exposed surfaces of semiconductor body 200. Optionally, a layer of oxide may now be deposited and anisotropically etched to extend sidewall oxides 248. Finally, the horizontal surfaces of gate 240 and source/drain 250 may be silicided. Sidewall oxides 248 function to prevent leakage by keeping the silicided regions away from the diffusion edges.

Field plate 228 may optionally be used as a ground plane. One method for accomplishing this will now be described. Oxide layer 230 is patterned and etched to expose a portion of field plate 228 where contact 258 is to be formed. Next, a conductive layer 260 is deposited, patterned and etched, as shown in Figure 3h, to form a contact 258 to field plate 228. Figure 3h shows a connection via contact 258 between field plate 228 and source/drain 264 of transistor 262. Other methods will be apparent to those skilled in the art and will of course depend on the device elements desired to be connected to ground.

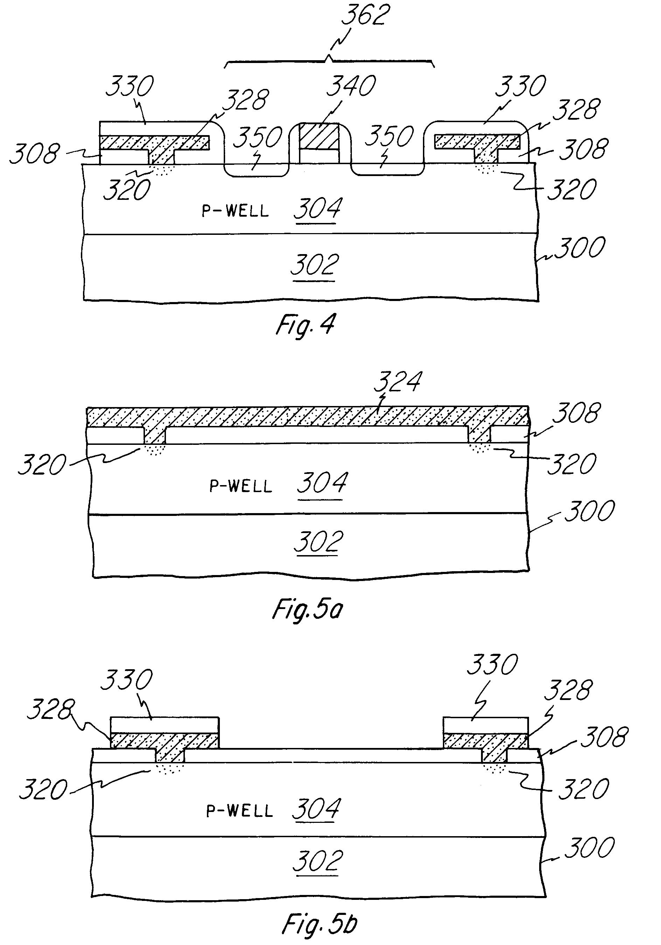

A second preferred embodiment of the invention is shown in Figure 4 and will now be described. Field plate 328 is embedded in and covers oxide layer 308, for example to isolate transistor 362 formed in p-well 304 from a second transistor (not shown) formed on the opposite side of field plate 328. Similar structures may be formed in either the p-well 304 or n-well (not shown). Field plate 328 contacts p-well 304 through channel stop region 320 and may also serve as a ground plane to be contacted in subsequent processing. BPSG layer 330 covers field plate 328 and prevents the formation of polysilicon filaments that can occur during a polysilicon etch such as that used in forming gate 340.

The formation of a field plate isolation according to the second preferred embodiment in a semiconductor body 300 having an n-type single crystal silicon substrate 302 after the formation of a buried p-well 304 will now be described.

Referring to figure 5a, oxide layer 308 is thermally grown on the surface of semiconductor body 300. The thickness of oxide layer 308 is typically on the order of 500 Å. Oxide layer 308 is patterned and etched to expose a portion of p-well 304 where field plate 328 is to be formed. Next, a layer of conductive material 324 is deposited. In the preferred embodiment, layer 324 is polysilicon. Typically, the thickness of the plate material will range between 1000 and 2000 Å. Conductive layer 324 is then doped to form the buried contact and channel stop region 320. Next, an anneal is performed to drive the junction out of the polysilicon layer.

Alternatively, conductive layer 324 may be made of silicide or refractory metal. If either silicide or refractory metal is used, then after the step of etching oxide layer 308, the exposed portion of p-well 304 is implanted with Boron to form channel stop region 320. (Phosphorous would be used for an n-well). After the formation of C/S region 320, silicide or refractory metal is deposited to form conductive layer 324.

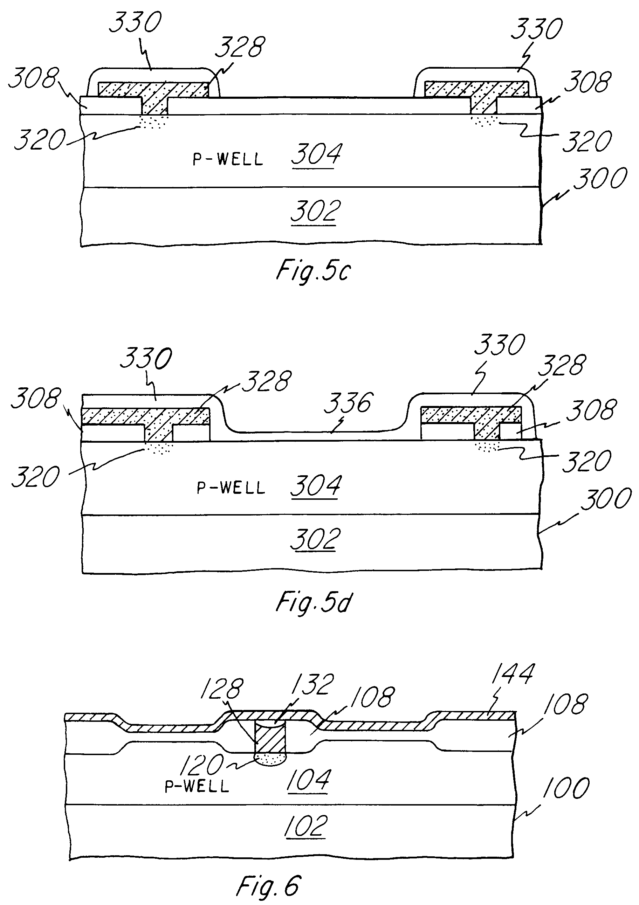

Referring to Figure 5b, a layer of BPSG (Boron Phosphorous Silicate Glass) 330 is deposited over conductive layer 324. Alternatively, a layer of PSG (Phosphorous Silicate Glass) may be used. The thickness of BPSG layer 330 is on the order of 2500 Å. BPSG layer 330 and conductive layer 324 are etched to expose portions of oxide layer 308 where transistors, such as transistor 262, are to be formed. As a result of the etching step, field plate 328 is formed. Semiconductor body 300 is then heated to a temperature on the order of 900°C, such that BPSG layer 330 reflows, as shown in Figure 5c. The reflow step creates a softer corner and thus reduces the need for a highly selective etch to remove polysilicon filaments that could otherwise occur when the polysilicon gates are formed.

After BPSG layer 330 is reflowed, a dry deglaze is performed to expose the surface area of semiconductor body 300 where transistors, such as transistor 362, are to be formed. A dry deglaze is preferred over a wet etch as a wet etch could remove too much of the BPSG layer 330. Gate oxide layer 336 is then grown in the exposed surfaces, as shown in Figure 5d. Methods for growing gate oxide layer 336 are well known in the art. However, a low temperature process should be used to avoid reflowing BPSG layer 330.

Subsequent to the completion of the method described above, transistors, such as transistor 362, and other elements, as well as connections therebetween, are formed into semiconductor device 300. Methods for forming such elements are well known in the art.

The field plate isolation structure of a third preferred embodiment of the invention is shown in Figure 6. Field plate 128 is embedded in field oxide 108, for example to isolate two transistors (not shown), formed on opposite sides of field plate 128 from one another. Oxide cap 132 covers field plate 128 to isolate it from gate lead 144. Optionally, there may be a channel stop region 120 below field plate 128.

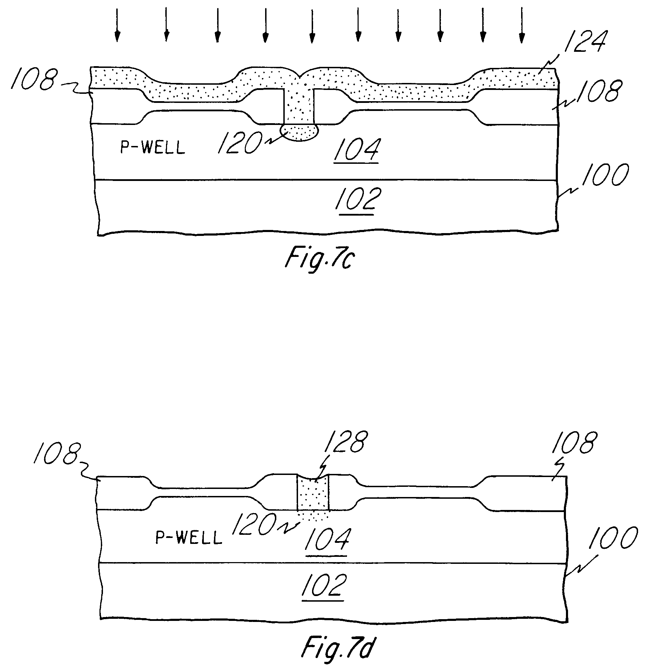

Figures 7a is cross-sectional diagram of a semiconductor body 100 having an n-type single crystal silicon substrate 102 after the formation of a p-well 104 and field oxide region 108. The formation of a field plate isolation in the structure of Figure 7a will now be described.

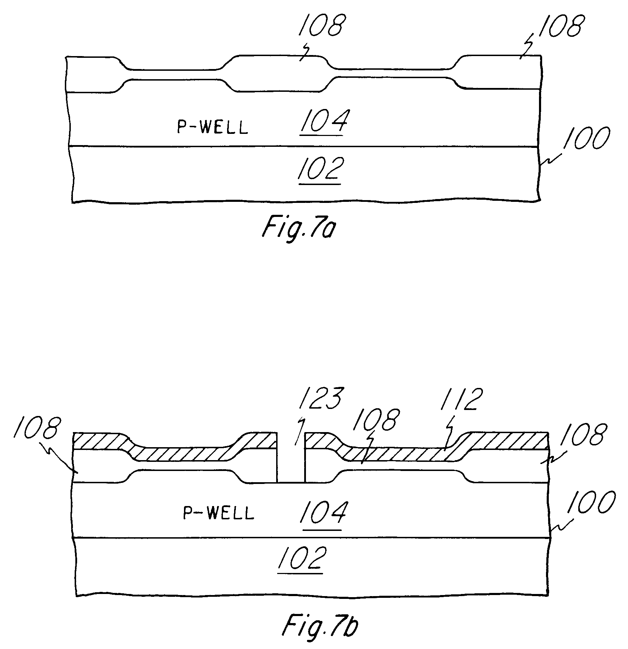

A masking layer 112, such as photoresist, is lithographically patterned as shown in Figure 7b to expose the area 123 of field oxide region 108 where the field plate 128 is to be formed. The shape of the field plate 128 is a slot whose width depends on available area and is typically .8 microns or greater. Field oxide region 108 is etched by conventional techniques to expose a portion of p-well 104. Masking layer 112 is then removed.

Next, a layer of conductive material 124, such as polysilicon or silicide is deposited as shown in Figure 7c. The thickness of conductive layer 124 depends on the width of field plate 128. Typically, the thickness will range between 4000 and 6000 Å. Conductive layer 124 is then doped to form the buried contact including channel stop region 120. If only n-channel isolation is required, then Boron may be used to dope conductive layer 124 according to conventional techniques (e.g., 7E13 Boron/cm² at 65 KEV). If both n-channel and p-channel isolation is required, conventional patterned n+/p+ implants may be used (e.g., Boron/Phosphorous). An alternative to doping conductive layer 124 would be to implant the exposed portion of p-well 104 prior to depositing conductive layer 124 to create channel stop region 120.

As shown in Figure 7d, a blanket etchback is performed to remove portions of conductive layer 124 until only field plate 128 remains. Next, the high voltage gate oxides and low voltage gate oxides are grown according to conventional techniques. During the oxide growth, an oxide cap 132 is formed above field plate 128. Oxide cap 132 grows at a faster rate than the high and low voltage gate oxides due to the enhanced oxidation rate of heavily doped field plate 128. The thickness of oxide cap 132 will accordingly depend on the desired thickness of the high voltage and low voltage gate oxides. Typically, oxide cap 132 will be in the range of .8 to 1.2 microns. When the gate leads 144 are formed, field plate 128 will be isolated from the gate leads 144 as shown in Figure 6.

Subsequent to the completion of the method described above, transistors and other elements, as well as connections therebetween, are formed into semiconductor device 100. Methods for forming such elements are well known in the art. Individual circuits are then separated from portions of substrate 102 and external connections made thereto by way of wire bonding, direct bump bonding, or the like, as is well known in the art. The individual circuits may then be packaged into a dual-in-line package, a chip carrier, or another type of package. An example of such a package is described in U.S. Patent No. 4,495,376 issued January 22, 1985 and assigned to Texas Instruments, Inc.

A few preferred embodiments have been described in detail hereinabove. It is to be understood that the scope of the invention also comprehends embodiments different from those described, yet within the scope of the claims.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A structure for isolating devices formed in a surface of a semiconductor body comprising:
a first well region of a first conductivity type formed in said semiconductor body;
a field oxide region located above said first well region extending between said devices; and
a field plate embedded in said field oxide region such that a portion of said field plate extends through said field oxide region to said first well region.

2. The structure of claim 1, further comprising first and second devices and wherein said devices are located in said first well region.

3. The structure of claim 1, wherein said first device is located in said first well region and said second device is located in a second well region of a second conductivity type.

4. The structure of any preceding claim, wherein said first and second devices are transistors.

5. The structure of any preceding claim, wherein said field plate comprises polysilicon.

6. The structure of any of claims 1 to 4, wherein said field plate comprises refractory metal.

7. The structure of any of claims 1 to 4, wherein said field plate comprises silicide.

8. The structure of any preceding claim, further comprising a doped region of said semiconductor body located below said field plate.

9. The structure of any preceding claim, further comprising an oxide cap above said field plate for isolating said field plate.

10. The structure of claim 9, wherein the oxide layer comprises a TEOS oxide layer.

11. The structure of claim 9, wherein the oxide layer comprises a layer of BPSG.

12. The structure of claim 9, wherein the oxide layer comprises a layer of PSG.

13. The structure of any preceding claim, further comprising a ground plate connection connected between said field plate and said first device.

14. A method for isolating devices formed in a surface of a semiconductor body comprising the steps of:
forming a well region of a first conductivity type in the surface of said semiconductor body;
forming a field oxide region at the surface of said semiconductor body over a first portion of said well region;
forming conductive layer to form a field plate over a second portion of said well region such that field plate does not extend above said field oxide region.

15. The method of claim 14, further comprising the steps of:
implanting said well region in the surface of said semiconductor body;
etching said oxide layer to expose a second portion of said well region wherein said first portion encompasses said second portion;
depositing a first layer of conductive material over the surface of said semiconductor body;
depositing a second layer of oxide over said first layer of conductive material;
etching second oxide layer, said first conductive layer and said first oxide layer to form a field plate having a vertical portion embedded in said first oxide layer and a horizontal portion covering said rust oxide layer;
depositing a third layer of oxide over the surface of said semiconductor body; and
anisotropically etching said third oxide layer to form sidewalls on the vertical edges of said field plate.

16. The method of claim 15, further comprising:
doping said first conductive layer;
annealing said first conductive layer:
depositing a layer of insulating material over said first conductive layer, wherein said insulating material reflows at a first predetermined temperature;
etching said layer of insulating material and said polysilicon layer to remove portions thereof where said devices are to be formed;
heating the semiconductor body to said first predetermined temperature to reflow the layer of insulating material; and
etching said first oxide layer to remove portions thereof where said devices are to be formed.

17. The method of any of claims 14 to 16, further comprising providing said first conductive layer as polysilicon.

18. The method of any of claims 14 to 16, further comprising providing said first conductive layer as refractory metal.

19. The method of any of claims 14 to 16, further comprising providing said first conductive layer as silicide.

20. The method of any of claims 16 to 19, further comprising the steps of:
etching said insulating layer to expose a first portion of said first conductive layer;
depositing a layer of second conductive material over the surface of said semiconductor body; and
etching said second conductive layer to form a ground plate connection between said polysilicon and at least one of said devices in said semiconductor body.

21. The method of any of claims 16 to 20, further comprising providing said insulating layer as boron phosphorous silicate glass (BPSG).

22. The method of any of claims 16 to 20, further comprising providing said insulating layer as phosphorous silicate glass.
